# EUROPEAN PATENT APPLICATION

(11) **EP 4 261 892 A1**
(43) Date of publication of application: **18.10.2023**
(21) Application number: 21903500.3
(22) Date of filing: 10.12.2021
(51) Int. Cl.: H01L 29/06, H01L 29/24, H01L 29/78, H01L 29/12, H01L 29/739, H01L 21/336, H01L 29/861, H01L 29/868

(54) **SEMICONDUCTOR DEVICE**

(30) Priority: 11.12.2020 JP 2020205909
(71) Applicant: Flosfia Inc., Kyoto 615-8245 (JP)
(72) Inventor: HIGUCHI, Yasushi, Kyoto-shi, Kyoto 615-8245 (JP); SHINOHE, Takashi, Kyoto-shi, Kyoto 615-8245 (JP)
(74) Representative: Gulde & Partner
(86) International application number: PCT/JP2021/045616
(87) International publication number: WO 2022/124404

(57) **Abstract**

An object of the disclosure is to provide a semiconductor device having a structure to suppress hole injections into the gate insulator. A semiconductor device including a gate insulating film, a hole blocking layer placed in contact with the gate insulating film, and an oxide semiconductor layer placed in contact with the hole blocking layer, wherein the hole blocking layer is located between the gate insulating film and the oxide semiconductor layer.

## Description

### Technical Field

The disclosure relates to a semiconductor device.

The disclosure also relates to a system employing the semiconductor device.

### Background Art

A semiconductor device with an interface of a metal oxide and a semiconductor (MOS interface) is known. For example, Patent Document 1 discloses a semiconductor device having a Ga₂O₃-based semiconductor layer and a gate insulating film placed in contact with the semiconductor layer. In the case of such a structure, if the semiconductor layer is a p-type semiconductor layer, holes are injected from the semiconductor layer to the gate insulating film placed in contact with the semiconductor layer. It may cause deterioration of lifetime and fluctuation of characteristics of the gate insulating film.

As materials for the semiconductor layer, nitride semiconductors such as SiC (silicon carbide), GaN (gallium nitride), InN (indium nitride), AlN (aluminum nitride) and the mixed crystals thereof are known. In addition, a semiconductor device using Ga₂O₃ (gallium oxide) having higher band gap than the semiconductor materials described above attracts attention as a crystalline oxide semiconductor material for the next generation capable of realizing higher withstand voltage and low-loss. Semiconductor devices containing crystalline oxide semiconductors with higher band gap are expected to be applied to semiconductor devices for power applications as switching devices. Since gallium oxide has a wider band gap, it is also expected to be applied as a light receiving or emitting devices such as LEDs or sensors.

It is known that gallium oxide has five crystal structures of α-type, β-type, γ-type, δ-type, and ε-type. Among them, gallium oxide having a corundum structure has a high band gap, and attracts attention as a semiconductor material for next-generation power devices. However, since the most stable phase of gallium oxide has a β-gallia structure, gallium oxide having a corundum structure as a metastable phase has difficulty in depositing without using a special method. Thermal behavior or the like of the crystalline film containing gallium oxide having a corundum structure is unknown in a semiconductor device and that has been a problem. In this regard, some studies have been conducted on crystalline oxide semiconductor films containing gallium oxide and mixed crystals thereof, including deposition of crystalline semiconductors having a corundum structure. For example, band gap of the gallium oxide disclosed in Patent Document 2 can be controlled by mixing indium and aluminum, respectively, or by mixing both indium and aluminum, to constitute a mixed crystal. The gallium oxide is described as a InAlGaO-based semiconductor. Here, InAlGaO-based semiconductors indicate In_{X}Al_{Y}Ga_{Z}O₃ (0≤X≤2, 0≤ Y≤2, 0≤Z≤2, X+Y+Z=1.5-2.5) and can be regarded as material system commonly containing gallium oxide.

However, in a semiconductor device using oxide semiconductors having higher band gap such as gallium oxide and a mixed crystal of gallium oxide and aluminum oxide, lifetime is deteriorated and characteristics are fluctuated of a gate insulating film connected to a p-type semiconductor layer (channel layer) and a n⁻-type semiconductor layer (drift layer) . As such, a semiconductor device containing an oxide semiconductor such as a InAlGaO based semiconductor capable of preventing degradation of characteristics and the like of the gate insulating film and expecting excellent reliability has been desired.

Patent Document 1: International Patent Application Publication No. 2013/035843
Patent Document 2: International Patent Application Publication No. 2014/050793

An object of the disclosure is to provide a semiconductor device of excellent reliability by suppressing degradation of characteristics of the gate insulating film.

As a result of intensive studies to achieve the above object, inventors provide a semiconductor device including a gate insulating film, a hole blocking layer placed in contact with the gate insulating film, and an oxide semiconductor layer placed in contact with the hole blocking layer, wherein the hole blocking layer is located between the gate insulating film and the oxide semiconductor layer. By such configuration, above-described problem is solved, and the semiconductor device in excellent reliability is obtained by suppressing degradation of characteristics of the gate insulating film.

After the above findings, the inventors have made further research and reach the disclosure.

Embodiments of the disclosure are as follows.
[1] A semiconductor device including a gate insulating film, a hole blocking layer placed in contact with the gate insulating film, and an oxide semiconductor layer placed in contact with the hole blocking layer, wherein the hole blocking layer is located between the gate insulating film and the oxide semiconductor layer.
[2] The semiconductor device according to [1], wherein the hole blocking layer has a first conductivity type and the oxide semiconductor layer has a second conductivity type that differs from the first conductivity type.
[3] The semiconductor device according to [1] or [2], wherein the band gap of the hole blocking layer and the band gap of the oxide semiconductor layer are different.
[4] The semiconductor device according to any one of [1] to [3], wherein the hole blocking layer is an oxide layer.
[5] The semiconductor device according to any one of [1] to [4], wherein the gate insulating film, the hole blocking layer, and the oxide semiconductor layer are partly arranged side by side in a horizontal direction in plan view.
[6] The semiconductor device according to any one of [1] to [5], wherein the hole blocking layer has n-type conductivity and the oxide semiconductor layer has p-type conductivity.
[7] The semiconductor device according to [5] or [6], wherein the oxide semiconductor layer contains at least one metal selected from gallium, iridium, nickel, rhodium, and chromium.
[8] The semiconductor device according to any one of [5] to [7], wherein an interface between the oxide semiconductor layer and the hole blocking layer forms a barrier that prevents injection of holes from the oxide semiconductor layer.
[9] The semiconductor device according to any one of [5] to [8], wherein a barrier height to holes at the interface between the oxide semiconductor layer and the hole blocking layer is 1.0eV or more.
[10] The semiconductor device according to any one of [1] to [4], wherein the oxide semiconductor layer has an n-type conductivity type.
[11] The semiconductor device according to [10], wherein the hole blocking layer has p-type conductivity.
[12] The semiconductor device according to [10] or [11], wherein the oxide semiconductor layer contains at least one metal selected from gallium, aluminum and indium.
[13] The semiconductor device according to any one of [10] to [12], wherein an interface between the gate insulating film and the hole blocking layer forms a barrier that prevents injection of holes from the oxide semiconductor layer.
[14] The semiconductor device according to any one of [10] to [13], wherein a barrier height to holes at the interface between the gate insulating film and the hole blocking layer is 1.0eV or more.
[15] The semiconductor device according to any one of [5] to [14], further including an n-type oxide layer placed in contact with the oxide semiconducting layer.
[16] The semiconductor device according to any one of [5] to [14], further including a p-type oxide layer placed in contact with the oxide semiconductor layer.
[17] A semiconductor device including a gate insulating film, an n-type hole blocking layer placed in contact with the gate insulating film, a p-type oxide layer placed in contact with the n-type hole blocking layer, a p-type hole blocking layer placed in contact with at least a part of the gate insulating film, and an n-type oxide layer placed in contact with the p-type hole blocking layer, wherein the p-type hole blocking layer and the p-type oxide layer are partly connected.
[18] A system including a circuit, and a semiconductor device electrically connected to the circuit, wherein the semiconductor device is of any one of [1] to [17].

### Advantageous Effect of Invention

According to the disclosure, it is possible to provide the semiconductor device of excellent reliability by suppressing degradation of characteristics of the gate insulating film.

### Brief Description of Drawings

Fig. 1A is an overhead view illustrating an outline of a cross-sectional configuration of a semiconductor device of a first embodiment of the disclosure.
Fig. 1B is a cross-sectional view illustrating the semiconductor device cut with a line Ib-Ib of Fig. 1A.
Fig. 1C is an overhead view illustrating an outline of a cross-sectional configuration of a semiconductor device of one or more embodiments of the disclosure.
Fig. 1D is an energy band diagram of the semiconductor device according to the first embodiment, in the case where the semiconductor device is configured by a gate insulating film, a hole blocking layer placed in contact with the gate insulating film, and an oxide semiconductor layer placed in contact with the hole blocking layer, and where applied gate voltage Vg is 0V and 10V.
Fig. 2A is an overhead view illustrating an outline of a cross-sectional configuration of a semiconductor device according to a second embodiment of the disclosure.
Fig. 2B is a cross-sectional view illustrating the semiconductor device cut with a line IIb-IIb of Fig. 2A.
Fig. 2C is an overhead view illustrating an outline of a cross-sectional configuration of a semiconductor device of one or more embodiments of the disclosure.
Fig. 2D is an energy band diagram of the semiconductor device according to the second embodiment, in the case where the semiconductor device is configured by a gate insulating film, a hole blocking layer placed in contact with the gate insulating film, and an oxide semiconductor layer placed in contact with the hole blocking layer, and where applied gate voltage Vg is 0V.
Fig. 3 is an overhead view illustrating an outline of a cross-sectional configuration of a semiconductor device according to a third embodiment.
Fig. 4A is an overhead view illustrating an outline of a cross-sectional configuration of a semiconductor device of according to a fourth embodiment.
Fig. 4B is a cross-sectional view illustrating the semiconductor device cut with a line IVb-IVb of Fig. 4A.
Fig. 5 is a block diagram illustrating an example of a control system employing a semiconductor device according to one or more embodiments of the disclosure.
Fig. 6 is a circuit diagram illustrating an example of a control system employing a semiconductor device according to one or more embodiments of the disclosure.
Fig. 7 is a block diagram illustrating an example of a control system employing a semiconductor device according to one or more embodiments of the disclosure.
Fig. 8 is a circuit diagram illustrating an example of a control system employing a semiconductor device according to one or more embodiments of the disclosure.
FIG. 9 is a diagram illustrating a mist CVD apparatus used for a semiconductor device according to one or more embodiments of the disclosure.

### [Description of Embodiments]

The semiconductor device according to one or more embodiments of the disclosure include a gate insulating film, a hole blocking layer placed in contact with the gate insulating film, and an oxide semiconductor layer placed in contact with the hole blocking layer, wherein the hole blocking layer is located between the gate insulating film and the oxide semiconductor layer. The semiconductor device according to one embodiment of the disclosure include a gate insulating film, an n-type hole blocking layer placed in contact with the gate insulating film, a p-type oxide layer placed in contact with the n-type hole blocking layer, a p-type hole blocking layer placed in contact with at least a part of the gate insulating film, and an n-type oxide layer placed in contact with the p-type hole blocking layer, and wherein the p-type hole blocking layer and the p-type oxide layer are partly connected.

The hole blocking layer is a layer applied to prevent injection of holes from the oxide semiconductor layer to the gate insulating film. The oxide semiconductor layer may be a multilayer. The hole blocking layer may include a plurality of regions for preventing injection of holes. The oxide semiconductor layer may have a trench, and the hole blocking layer may be disposed between the oxide semiconductor layer and the gate insulating film provided over the bottom and side surfaces of the trench. As will be described later, the shape of the hole blocking layer varies in the case of being disposed at a position adjacent to the side surface of the trench and in the case of being disposed at a position adjacent to the bottom surface of the trench. In one or more embodiments of the disclosure, the conductivity type of the hole blocking layer is preferably different from the conductivity type of the oxide semiconductor layer having the trench. In one or more embodiments of the disclosure, it is preferable that the hole blocking layer includes an oxide layer. Examples of materials for constituting the hole blocking layer include metal oxides containing one or more kinds of metals selected from aluminum, gallium, indium, iron, chromium, vanadium, titanium, rhodium, nickel, cobalt and iridium. When the conductivity type of the hole blocking layer is n-type, the hole blocking layer preferably contains at least one metal selected from aluminum, indium, and gallium, more preferably includes as a main component a metal oxide containing at least one metal selected from aluminum, indium, and gallium, still more preferably includes as a main component a metal oxide containing at least gallium, and most preferably is α-Ga₂O₃ or a mixed crystal thereof. In one or more embodiments of the disclosure, it is also preferable that the hole blocking layer contains as a main component a metal oxide containing indium and gallium. When the conductivity type of the hole blocking layer is p-type, the hole blocking layer preferably contains at least one metal selected from gallium, iridium, nickel, rhodium, and chromium, and more preferably includes as a main component a metal oxide containing at least one metal selected from gallium, iridium, nickel, rhodium, and chromium. Note that the term "main component" means that the atomic ratio of the metal oxide to all components of the hole blocking layer is preferably 50% or more, more preferably 70% or more, and even more preferably 90% or more, and may be 100%. In the case where the oxide semiconductor layer having the trench is an n-type oxide semiconductor layer (a layer of at least one semiconductor selected from an n-type gallium oxide semiconductor, an n-type aluminum gallium oxide semiconductor, an n-type indium gallium oxide semiconductor, and an n-type indium aluminum gallium oxide semiconductor, for example), the hole blocking layer is preferably a p-type oxide layer (a layer of at least one oxide selected from p-type iridium gallium oxide, Mg-doped gallium oxide, for example). In one or more embodiments of the disclosure, it is preferable that the hole blocking layer has a barrier of 1.0eV or more so as to perform as a barrier to holes in the oxide semiconductor layer. The hole blocking layer may be formed by the same method as the oxide semiconductor layer described later.

The oxide semiconductor layer is not particularly limited as long as it does not deviate the object of the disclosure. In one or more embodiments of the disclosure, it is preferable that the oxide semiconductor layer is a crystalline oxide semiconductor layer. Examples of constituent materials of the oxide semiconductor layer include a metal oxide containing one or more kinds of metals selected from aluminum, gallium, indium, iron, chromium, vanadium, titanium, rhodium, nickel, cobalt and iridium. Conductivity type of the oxide semiconductor layer is not particularly limited, and may be n-type or p-type. When the conductivity type of the oxide semiconductor layer is n-type, the oxide semiconductor layer preferably contains at least one metal selected from aluminum, indium, and gallium, more preferably contains a metal oxide of at least one metal selected from aluminum, indium and gallium as a main component, still more preferably contains a metal oxide containing at least gallium as a main component, and most preferably is α-Ga₂O₃ or a mixed crystal thereof.

When the conductivity type of the oxide semiconductor layer is p-type, the oxide semiconductor layer preferably contains at least one metal selected from gallium, iridium, nickel, rhodium, and chromium, and more preferably contains a metal oxide of at least one metal selected from gallium, iridium, nickel, rhodium and chromium as a main component. Note that the term "main component" means that the atomic ratio of the metal oxide to all components of the oxide semiconductor layer is preferably 50% or more, more preferably 70% or more, and even more preferably 90% or more, and may be 100%. Crystal structure of the crystalline oxide semiconductor layer is not particularly limited as long as it does not deviate the object of the disclosure. Examples of the crystal structure of the crystalline oxide semiconductor layer include corundum structure, β-gallia structure, hexagonal crystal structure (e.g., ε-type structure), orthogonal crystal structure (e.g., κ-type structure), cubic crystal structure, or tetragonal crystal structure. In one or more embodiments of the disclosure, the crystalline oxide semiconductor layer preferably has corundum structure, β-gallia structure, or hexagonal crystal structure (e.g., an ε-type structure), and more preferably has corundum structure. Thickness of the oxide semiconductor layer is not particularly limited, and may be 1µm or less, or 1µm or more. A surface area of the oxide semiconductor layer is not particularly limited, but may be 1mm² or more, may be 1mm² or less, preferably 10mm² to 300cm², more preferably 100mm² to 100cm². The crystalline oxide semiconductor layer may be single crystal or polycrystalline. In one or more embodiments of the disclosure, it is preferable that the crystalline oxide semiconductor layer is a single crystal layer.

The oxide semiconductor layer preferably contains a dopant. Material of the dopant is not particularly limited and may be a known one. In one or more embodiments of the disclosure, preferable examples of the dopant include an n-type dopant such as tin, germanium, silicon, titanium, zirconium, vanadium, or niobium when the conductivity type of the oxide semiconductor layer is n-type. When the conductivity type of the oxide semiconductor layer is p-type, a p-type dopant such as magnesium, calcium, or zinc may be used. Content of the dopant is preferable 0.00001 atomic% or more, more preferably 0.00001 atomic% to 20 atomic%, and most preferably 0.00001 atomic% to 10 atomic% in the composition of the semiconductor layer. More specifically, concentration of the dopant may typically be about 1×10¹⁶/cm³ to 1×10²²/cm³, and the concentration of the dopant may be as low as, for example, about 1×10¹⁷/cm³ or less. In one or more embodiments of the disclosure, dopants may be contained in high concentrations of about 1×10²⁰/cm³ or more. In one or more embodiment of the disclosure, it is preferable that the semiconductor layer contains a dopant at a dopant concentration of 1×10¹⁷/cm³ or more in the semiconductor layer.

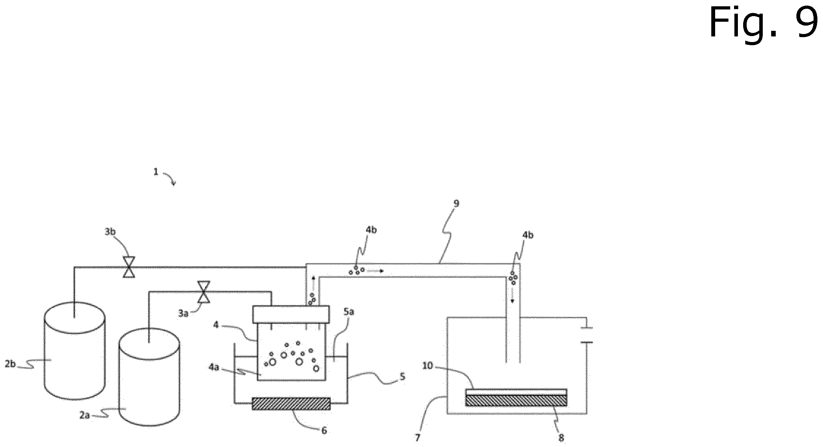

The oxide semiconductor layer (hereinafter also referred to as a "semiconductor layer" or a "semiconductor film") may be formed by a known method. As a method for forming the semiconductor layer, CVD method, MOCVD method, MOVPE method, mist-CVD method, mist-epitaxy method, MBE method, HVPE method, pulsed growth method or ALD method, and the like. In one or more embodiments of the disclosure, the method of forming the semiconductor layer is preferably MOCVD method, mist CVD method, mist epitaxy method, or HVPE method, and more preferably mist CVD method or mist epitaxy method. In the mist CVD method or the mist epitaxy method, for example, a mist CVD apparatus shown in Fig. 9 is used to atomize a raw material solution to float droplets (atomizing step), and thereafter, atomized droplets are conveyed to the vicinity of a base by a carrier gas (conveying step), and then the atomized droplets are thermally reacted in the vicinity of the base, whereby a semiconductor film containing the crystalline oxide semiconductor as a main component is deposited on the base (deposition step) to form the semiconductor layer on the base.

### (Atomizing step)

In atomization step, the raw material solution is atomized. The method of atomizing the raw material solution is not particularly limited as long as the raw material solution can be atomized, and may be a known method. In one or more embodiments of the disclosure, using ultrasonic waves is preferable for the atomizing method. Droplets atomized using ultrasonic waves are preferred because they have an initial velocity of zero and are floated in the air. The atomized droplets are not sprayed as in a spray, for example, but are a mist which may float in a space and be conveyed as a gas, so that there is no damage due to collision energy which is very suitable. The droplet size is not particularly limited and may be a droplet of about several millimeters, preferably 50µm or less, and more preferably 100nm to 10µm.

### (Raw material solution)

The raw material solution is not particularly limited as long as it is capable of atomization or droplet formation and contains a raw material capable of forming the semiconductor film. The raw material may be an inorganic material or an organic material. In one or more embodiments of the disclosure, the raw material is preferably a metal or a metal compound, and more preferably includes one or more metals selected from aluminum, gallium, indium, iron, chromium, vanadium, titanium, rhodium, nickel, cobalt and iridium.

In one or more embodiments of the disclosure, it is preferable to use a material in which the metal is dissolved or dispersed in an organic solvent or water in the form of a complex or a salt as the raw material solution. Examples of the form of the complex include an acetylacetonate complex, a carbonyl complex, an ammine complex, a hydride complex. Examples of the form of the salt include an organometallic salt (metal acetate, metal oxalate, metal citrate, and the like), a metal sulfide salt, a nitrified metal salt, a phosphorylated metal salt, and a halogenated metal salt (metal chloride, metal bromide, metal iodide, and the like).

In the raw material solution, it is preferable to mix an additive such as a hydrohalic acid or an oxidizing agent. Examples of the hydrohalic acid include hydrobromic acid, hydrochloric acid, and hydroiodic acid. For the reason that the occurrence of abnormal grains may be more efficiently suppressed, hydrobromic acid or hydroiodic acid is more preferable. Examples of the oxidizing agent include peroxides such as hydrogen peroxide (H₂O₂), sodium peroxide (Na₂O₂), barium peroxide (BaO2₂), benzoyl peroxide (C₆H₅CO)₂O₂), and organic peroxides such as hypochlorous acid (HClO), perchloric acid, nitric acid, ozonated water, peracetic acid and nitrobenzene.

A dopant may be contained in the raw material solution. By including a dopant in the raw material solution, doping may be performed well. Material for the dopant is not particularly limited as long as it does not deviate the object of the disclosure. Examples of the dopant include an n-type dopant such as tin, germanium, silicon, titanium, zirconium, vanadium, or niobium, or a p-type dopant such as Mg, H, Li, Na, K, Rb, Cs, Fr, Be, Ca, Sr, Ba, Ra, Mn, Fe, Co, Ni, Pd, Cu, Ag, Au, Zn, Cd, Hg, Ti, Pb, N, or P. The content of the dopant is appropriately set by referring to a calibration curve showing the relationship of the concentration of the dopant in the raw material with respect to the desired carrier density.

The solvent of the raw material solution is not particularly limited, and may be an inorganic solvent such as water, an organic solvent such as alcohol, or a mixed solvent of an inorganic solvent and an organic solvent. In one or more embodiments of the disclosure, the solvent preferably includes water, and more preferably, the solvent is water or a mixed solvent of water and alcohol.

### (Conveying step)

In the conveying step, the atomized droplets are conveyed into a deposition chamber using a carrier gas. The carrier gas is not particularly limited as long as it does not deviate the object of the disclosure, and examples thereof include an inert gas such as oxygen, ozone, nitrogen or argon, or a reducing gas such as hydrogen gas or a forming gas. The type of the carrier gas may be one, and two or more types may be accepted. A dilution gas (such as a 10-fold dilution gas) having a reduced flow rate may be further applied as the second carrier gas. The carrier gas may be supplied not only at one point but also at two or more points in the deposition chamber. The flow rate of the carrier gas is not particularly limited, and is preferably 0.01 to 20L/min, more preferably 1 to 10L/min. When the diluent gas is used, the flow rate of the diluent gas is preferably 0.001 to 2L/min, more preferably 0.1 to 1L/min.

### (Deposition step)

In the deposition step, the semiconductor film is deposited on the substrate by thermally reacting the atomized droplets in the vicinity of the base. The thermal reaction may be performed so long as the atomized droplets react with heat, and the reaction conditions and the like are not particularly limited as long as they do not deviate the object of the disclosure. In this deposition step, the thermal reaction is generally performed at a temperature equal to or higher than an evaporation temperature of the solvent, and in that case, a temperature (e.g., 1000 °C or less) which is not too high is preferable, more preferably 650 °C or less, and most preferably 300 °C to 650 °C. Further, the thermal reaction may be performed either under a vacuum, under a non-oxygen atmosphere (under an inert gas atmosphere or the like), under a reducing gas atmosphere, and under an oxygen atmosphere, as long as it does not deviate the object of the disclosure. Particularly, the thermal reaction is preferably performed under an inert gas atmosphere or under an oxygen atmosphere. The deposition step may be performed under any condition under atmospheric pressure, under pressure, and under reduced pressure, and in one or more embodiments of the disclosure, it is preferable that the deposition step is performed under atmospheric pressure. The film thickness may be set by adjusting the deposition time.

### (Base)

The base is not particularly limited as long as the base can support the semiconductor film. The material of the base is not particularly limited as long as it does not deviate the object of the disclosure, and may be a known material. The material of the base may be an organic compound or an inorganic compound. The shape of the base may be of any shape. The shape may be a plate such as a flat plate or a disc plate, fibrous, rod-like, column, prismatic, cylindrical, spiral, spherical and ring shape. In one or more embodiments of the disclosure, the shape of the substrate is preferably a plate. Thickness of the substrate is not particularly limited in one or more embodiments of the disclosure.

The substrate is not particularly limited as long as the substrate is a plate-shaped and can support the semiconductor film. The substrate may be an insulator substrate or a semiconductor substrate. The substrate may be a metal substrate or a conductive substrate, and in particular, an insulator substrate is preferable. A substrate having a metal film on its surface is also preferable. Examples of the substrate include a base substrate containing a material having a corundum structure as a main component, a base substrate containing a material having a β-gallia structure as a main component, and a base substrate containing a material having a hexagonal crystal structure as a main component. Here, the term "main component" means that the atomic ratio of the substrate material having the specific crystal structure to all components of the material constituting the substrate is preferably 50% or more, more preferably 70% or more, and still more preferably 90% or more, and may be 100%.

Material for the substrate is not particularly limited as long as it does not deviate the object of the disclosure, and may be a known one. As the substrate having the corundum structure, it is preferable to employ a α-Al₂O₃ (sapphire) substrate or a α-Ga₂O₃ substrate, and more preferably an a-plane sapphire substrate, an m-plane sapphire substrate, an r-plane sapphire substrate, a c-plane sapphire substrate, or a α-type gallium oxide substrate (a-plane, m-plane, or r-plane). As the base substrate containing the β-gallia-structured substrate material as a main component, β-Ga₂O₃ substrate, or a mixed crystal substrate containing Ga₂O₃ and Al₂O₃ in which Al₂O₃ is more than 0wt% and 60wt% or less may be selected for example. Examples of the base substrate containing the hexagonal-structured substrate material as a main component includes a SiC substrate, a ZnO substrate and a GaN substrate.

In one or more embodiments of the disclosure, annealing treatment may be performed after the deposition step. The temperature of the aforementioned annealing treatment is not limited especially unless deviating the object of the disclosure, and is generally 300 °C to 650 °C, and is preferably 350 °C to 550 °C. The processing time of the annealing treatment is generally in 1 minute to 48 hours, preferably in 10 minutes to 24 hours, and more preferably in 30 minutes to 12 hours. The annealing treatment may be performed under any atmosphere so long as it does not deviate the object of the disclosure. The atmosphere of the annealing treatment may be a non-oxygen atmosphere or an oxygen atmosphere. Examples of the non-oxygen atmosphere include an inert gas atmosphere (e.g., a nitrogen atmosphere) or a reducing gas atmosphere. In one or more embodiments of the disclosure, the non-oxygen atmosphere, preferably the inert gas atmosphere, more preferably the nitrogen atmosphere.

In one or more embodiments of the disclosure, the semiconductor film may be directly deposited on the substrate, or the semiconductor film may be deposited via another layer such as a stress relaxing layer (a buffer layer, an ELO layer, or the like), a release sacrifice layer, or the like. The method of forming each of the layers is not particularly limited, and may be a known method. In one or more embodiments of the disclosure, a method of forming each of the layers is preferably mist CVD method.

In one or more embodiments of the disclosure, the semiconductor film may be used in a semiconductor device as the semiconductor layer after the semiconductor film is peeled off from the base or the like by a known method, or the semiconductor film may be used in a semiconductor device as the semiconductor layer without being peeled off from the base or the like.

In one or more embodiments of the disclosure, the hole blocking layer preferably has a first conductivity type, and the oxide semiconductor layer preferably has a second conductivity type that is different from the first conductivity type. It is also preferable that the band gap of the hole blocking layer and the band gap of the oxide semiconductor layer is different. By such a preferable combination of the hole blocking layer and the oxide semiconductor layer, it is possible to suppress injection of holes into the gate insulating film favorably.

The gate insulating film is not particularly limited as long as it does not deviate the object of the disclosure. Suitable material for the gate insulating film include various types of oxides, such as SiO₂, Si₃N₄, Al₂O₃, Ga₂O₃, AlGaO, InAlGaO, AlInZnGaO₄, AlN, Hf₂O₃, SiN, SiON, MgO, GdO, oxide containing phosphorus, and the like. The gate insulating film may be formed by a known method, such as a dry method or a wet method. Examples of the dry method include known methods such as sputtering, vacuum evaporation, CVD, and PLD. Examples of the wet method include a coating method such as screen printing or die coating.

Hereinafter, some preferred embodiments will be described with reference to the drawings. Note that the disclosure is not limited thereto.

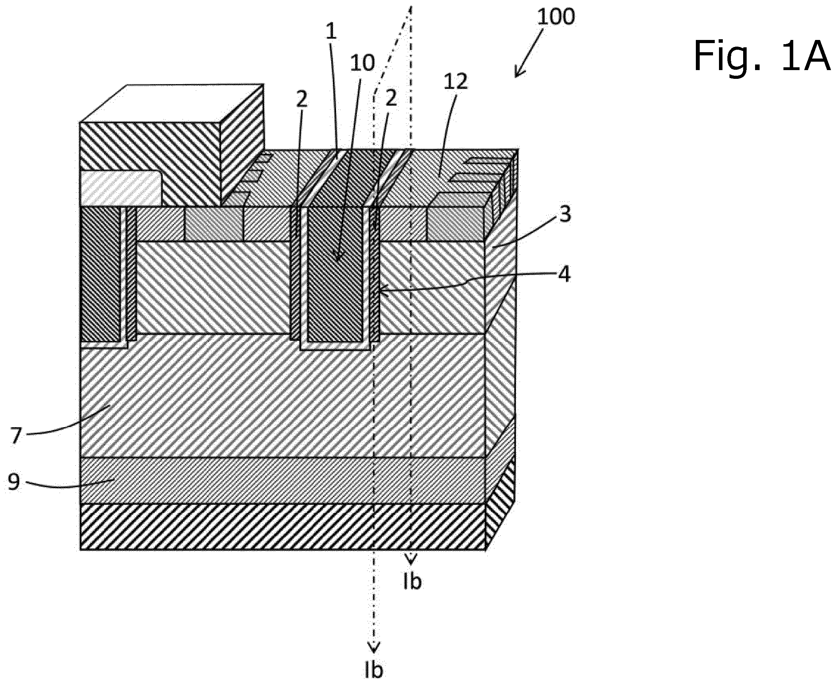

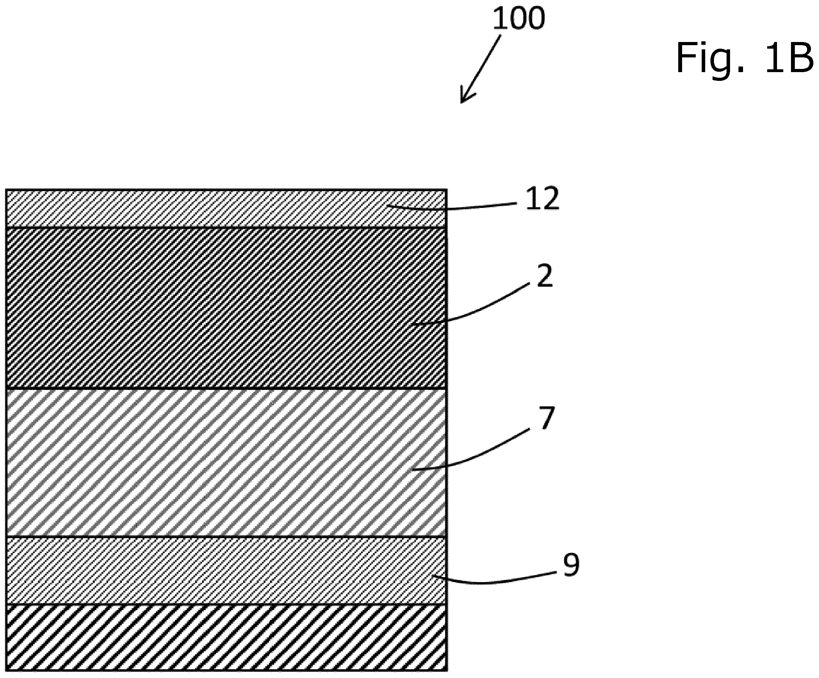

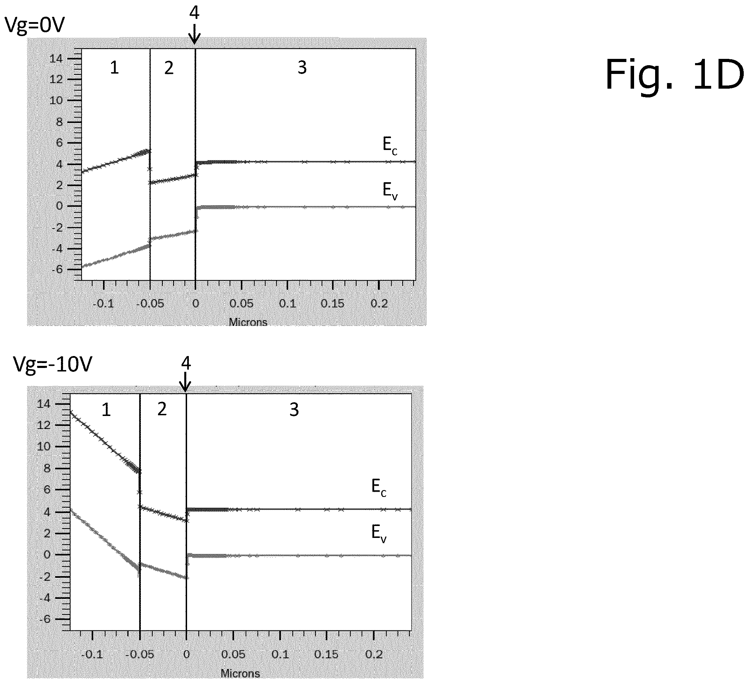

Fig. 1A is an overhead view illustrating an outline of a cross-sectional configuration of a semiconductor device according to the first embodiment of the disclosure. For the purpose of explaining main portions of the embodiment, Fig. 1A further shows configuration to depth direction of paper is illustrated by omitting a part of an electrode and an insulating film. Fig. 1B is a cross-sectional view taken along Ib-Ib line shown in Fig. 1A. A semiconductor device 100 includes a gate insulating film 1, a hole blocking layer 2 placed in contact with the gate insulating film 1, and an oxide semiconductor layer 3 placed in contact with the hole blocking layer 2. The hole blocking layer 2 is provided between the gate insulating film 1 and the oxide semiconductor layer 3. The gate insulating film 1, the hole blocking layer 2, and the oxide semiconductor layer 3 are configured to have a part in which they are arranged side by side in a horizontal direction in plan view. The oxide semiconductor layer 3 contains at least one metal selected from gallium, iridium, nickel, rhodium, and chromium. In the embodiment, the hole blocking layer 2 preferably has a first conductivity type and the oxide semiconductor layer 3 preferably has a second conductivity type different from the first conductivity type. For example, if the first conductivity type is an n-type conductivity type, the second conductivity type is a p-type conductivity type. As shown in Fig. 1A, it is preferable that the hole blocking layer 2 extends so as to continuously cover the gate insulating film 1 arranged along a trench 10 at least in the longitudinal direction and the depth direction of the side surfaces of the gate insulating film 1. With such a preferable configuration, injection of holes from the oxide semiconductor layer 3 into the gate insulating film 1may be more suitably suppressed. The effects of suppressing injection of holes in this embodiment will be described in detail with reference to an energy band diagram shown in Fig. 1D. In the semiconductor device 100, the gate insulating film 1 is a SiO₂ film and the oxide semiconductor layer 3 is a p-type iridium gallium oxide layer, for example. If a p-type gallium oxide layer (having same band structure as the hole blocking layer) or the like is placed in contact with the gate insulating film 1, since there is no barrier to holes between the gate insulating film 1 and the p-type gallium oxide layer, holes are injected from the p-type gallium oxide layer into the gate insulating film 1 and that causes deterioration of the gate insulating film 1. Therefore, by applying the p-type iridium gallium layer as the oxide semiconductor layer 3 and the n-type gallium oxide layer as the hole blocking layer, for example, the hole blocking layer may be disposed between the p-type iridium gallium oxide layer and the gate insulating film, and thereby a barrier against holes may be formed. The energy band diagram shown in Fig. 1D shows in the case of the gate voltages Vg of 0V and 10V. As can be seen from Fig. 1D, a barrier to holes exists at the interface 4 between the oxide semiconductor layer 3 as the p-type iridium gallium oxide layer and the hole blocking layer 2 as the n⁻-type gallium oxide layer. The barrier height for holes at the interface 4 between the oxide semiconductor layer 3 and the hole blocking layer 2 is 1.0eV or more. With the configuration as described above, in the semiconductor device containing an oxide semiconductor such as a InAlGaO based semiconductor, it is possible to suppress the injection of holes into the gate insulating film. In one or more embodiments of the disclosure, it is particularly preferable to use the hole blocking layer 2 having hole barrier of 1.0eV or more to the oxide semiconductor layer 3. With such a preferable configuration, injection of holes from the oxide semiconductor layer 3 into the gate insulating film 1 may be favorably suppressed, and the semiconductor device with more excellent reliability may be realized. Combination of materials of the oxide semiconductor layer 3 and the hole blocking layer 2 is not particularly limited as long as it forms a barrier to holes between the oxide semiconductor layer 3 and the hole blocking layer 2 and does not deviate the object of the disclosure.

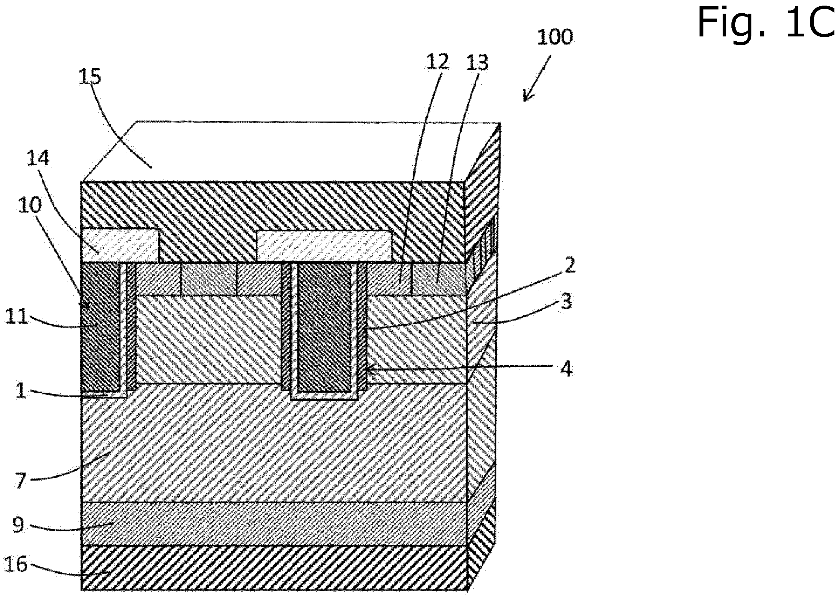

The semiconductor device 100 will be described in more detail. As shown in Fig. 1A, the semiconductor device 100 is disposed on the oxide semiconductor layer 3 and has a first semiconductor region 12 provided adjacent to an upper portion of side surfaces of the gate insulating film 1 disposed along the trench 10. It is preferable that upper end portions of the hole blocking layer 2 disposed between the oxide semiconductor layer 3 and the gate insulating film 1 is connected to and/or embedded in the first semiconductor region 12. In addition, it is preferable that the upper end portions of the hole blocking layer 2 are formed so as to be flush with the upper surface of the first semiconductor region 12, and thereby the hole blocking layer 2 may be easily formed. Further, the semiconductor device 100 has a second semiconductor region 13 disposed on the oxide semiconductor layer 3. As shown in Fig. 1A, the semiconductor device 100 has a portion where the first semiconductor region 12 and the second semiconductor region 13 are placed alternately. In one or more embodiments of the disclosure, it is preferable that the first semiconductor region 12 is n⁺-type semiconductor region and the second semiconductor region 13 is a p⁺-type semiconductor region. Fig. 1C shows a schematic cross-sectional view of the semiconductor device 100. The semiconductor device 100 includes a first electrode 11 (gate electrode) embedded in the trench 10, an inter-electrode insulating film 14 (source-gate film) provided to cover upper surfaces of the first electrode 11 and the gate insulating film 1 and to cover at least a part of the upper surface of the first semiconductor region 12, and a second electrode 15 (source electrode) provided to cover upper surfaces of the inter-electrode insulating film 14, the first semiconductor region 12, and the second semiconductor region 13. The semiconductor device 100 further includes a second oxide semiconductor layer 7 placed in contact with the semiconductor layer 3 (a first semiconductor layer) and provided such that the bottom of the trench 10 is embedded therein, an oxide layer 9 placed in contact with the second oxide semiconductor layer 7, and a third electrode 16 (drain electrode) provided to be connected to the oxide layer 9. The oxide semiconductor layer 7 contains at least one metal selected from gallium, aluminum, and indium.

The oxide semiconductor layer 3 contains at least one metal selected from iridium, nickel, rhodium, and chromium. The conductivity types of the second oxide semiconductor layer 7 and the oxide layer 9 is different from the conductivity type of the first oxide semiconductor layer 3. For example, if the first oxide semiconductor layer 3 is a p-type iridium gallium oxide layer, the second oxide semiconductor layer 7 is an n⁻-type gallium oxide semiconductor layer, and the oxide layer 9 is an n⁺-type gallium oxide semiconductor layer. The semiconductor device 100 of one or more embodiments is MOSFET(Metal-Oxide-Semiconductor Field Effect Transistor).

Examples of methods of manufacturing the semiconductor device shown in Fig. 1A will be described. First, the first oxide semiconductor layer 3 is formed on the second oxide semiconductor layer 7, and the first semiconductor region 12 is further formed on the first oxide semiconductor layer 3. Then, placing a mask for etching in an area of the first semiconductor region 12 except an area where the trench 10 is formed, and etching is performed from the upper surface of the first semiconductor region 12 to go through the first oxide semiconductor layer 3, and forming a groove with a depth reaching the second oxide semiconductor layer 7. Next, the hole blocking layer 2 is formed. A mask for deposition is disposed on the bottom surface of the trench 10, and the hole blocking layer 2 is formed only on the side surfaces of the trench 10 as shown in Fig. 1B by the deposition method described above. Examples of a method of forming the oxide semiconductor layer 7, the hole blocking layer 2, and the first semiconductor region 12 include, a deposition method such as a MOCVD method, a mist CVD method, a mist epitaxy method, or a HVPE method. As another aspect of the embodiment, the hole blocking layer 2 may be provided so as to cover the side surfaces and the bottom surface of the trench. In this case, it is not necessary to provide the mask for deposition on the bottom surface of the trench. Even for such an embodiment, an effect of suppressing injection of holes from the first oxide semiconductor layer 3 into the gate insulating film 1 may be obtained. After the hole blocking layer 2 is formed, the gate insulating film 1 is formed by covering the hole blocking layer 2 disposed in the trench 10. Examples of the method of forming the gate insulating film include a CVD method, an atmospheric pressure CVD method, a Plasma CVD method, and a mist CVD method. Next, the first electrode 11 (the gate electrode) is embedded in the trench 10 in which the gate insulating film 1 is disposed. Next, the inter-electrode insulating film 14 is formed, and the second electrode 15 is formed on the inter-electrode insulating film 14. Although forming the third electrode 16 on the opposite side of the second electrode 15 is possible thereafter, the order of forming electrodes is not limited in the disclosure. Note that method of forming the first electrode 11, the second electrode 15, and the third electrode 16 is not particularly limited, and may be a known method. Examples of the method for forming the first electrode 11 or the second electrode 15 include sputtering, vacuum evaporation, and CVD.

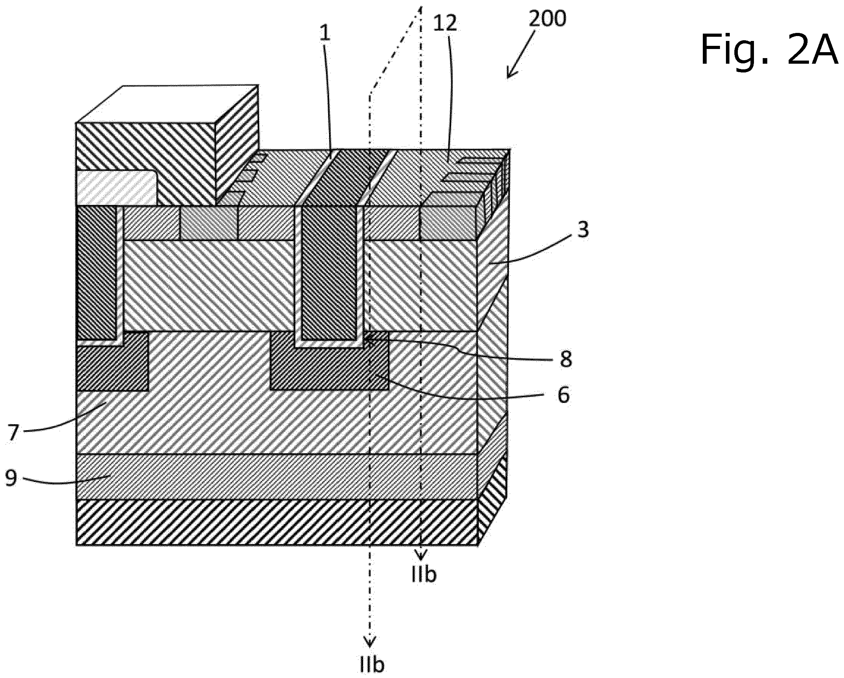

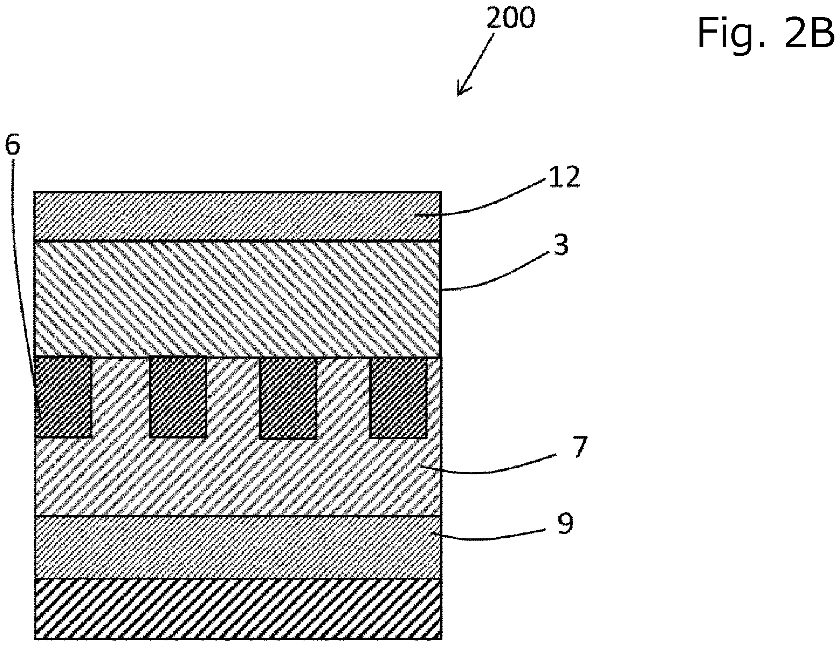

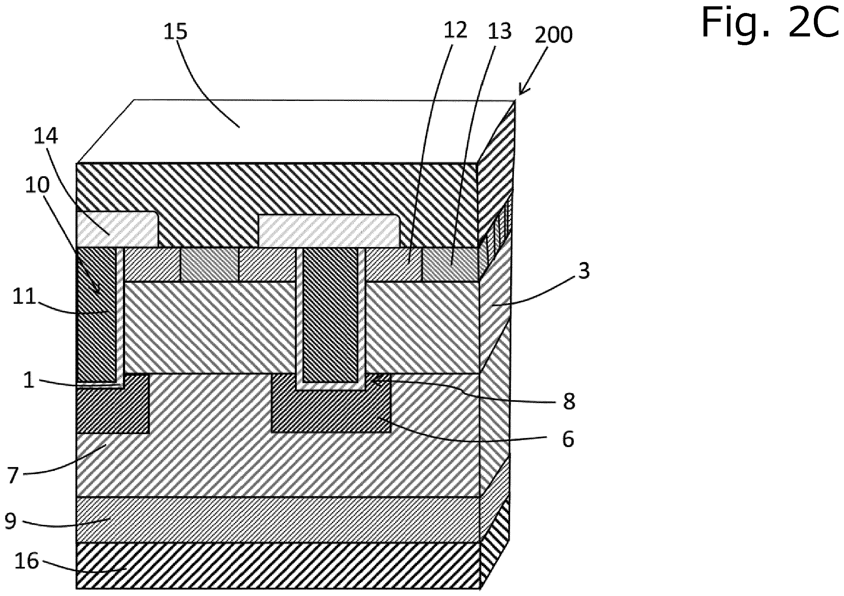

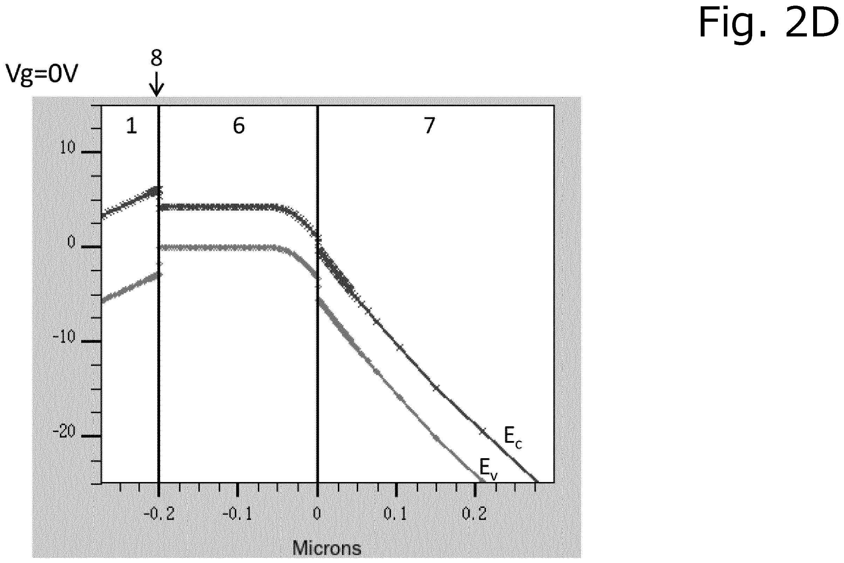

Fig. 2A is an overhead view illustrating an outline of a cross-sectional configuration of a semiconductor device according to a second embodiment of the disclosure. For the purpose of explaining main portions of the embodiment, Fig. 2A further shows configuration to depth direction of paper is illustrated by omitting a part of an electrode and an insulating film. Fig. 2B is a cross-sectional view taken along IIb-IIb line shown in Fig. 2A. A semiconductor device 200 includes the gate insulating film 1, a hole blocking layer 6 placed in contact with the gate insulating film 1, and the oxide semiconductor layer 7 connected to the hole blocking layer 6. The hole blocking layer 6 is provided between the gate insulating film 1 and the oxide semiconductor layer 7. As shown in Fig. 2B, the hole blocking layer 6 has a portion to cover the gate insulating film 1 at least at the bottom of the trench in the gate insulating film 1 arranged along the trench 10. In this embodiment, the hole blocking layer 6 does not have to extend so as to continuously cover the gate insulating film 1. Injection of holes from the oxide semiconductor layer 7 into the gate insulating film 1 may be suppressed as long as at least the hole blocking layer 6 is partially disposed. In this embodiment, the effects of suppressing injection of holes will be described in detail with reference to an energy band diagram shown in Fig. 2D. In the semiconductor device 200, the gate insulating film 1 is a SiO₂ layer, and the oxide semiconductor layer 7 is an n⁻-type gallium oxide layer. If the oxide semiconductor layer 7 is placed in contact with the gate insulating film 1, since there is no barrier to holes between the gate insulating film 1 and the oxide semiconductor layer 7, holes are injected from the oxide semiconductor layer 7 into the gate insulating film 1 and that causes deterioration of the gate insulating film 1. In this embodiment, for example, by disposing the hole blocking layer 6 of the p-type iridium gallium oxide layer between the oxide semiconductor layer 7 and the gate insulating film 1, a barrier against holes may be formed between the gate insulating film 1 and the hole blocking layer 6. By at least partially connecting the hole blocking layer 6 to the p-type oxide semiconductor layer 3 disposed on the n-type gallium oxide layer 7, path of holes generated in the n-type gallium oxide layer 7 to be discharged to the source electrode through the hole blocking layer 6 as the p-type iridium oxide layer may be secured. In this embodiment, it is only necessary to form a path for discharging holes by disposing the hole blocking layer 6. Combination of materials of the hole blocking layer 6 and the gate insulating film 1 is not particularly limited as long as it forms a barrier to holes between the hole blocking layer 6 and the gate insulating film 1 and does not deviate the object of the disclosure. Therefore, unlike the hole blocking layer 2 of the semiconductor device 100 in the first embodiment, the hole blocking layer 6 need not extend so as to continuously cover the gate insulating film 1 arranged along the trench 10 at least in the longitudinal direction and the depth direction of the side surfaces of the gate insulating film 1. In this embodiment, the hole blocking layer 6 may be arranged at spaced in the longitudinal direction of the side surfaces of the trench as a plurality of hole blocking regions, as shown in Fig. 2B. Holes discharged to the p⁻-type oxide semiconductor layer 3 are further discharged from the source electrode 15 via the second semiconductor region 13.

An example of methods of manufacturing the semiconductor device shown in Fig. 2A will be described. First, placing a mask on an upper surface of the second oxide semiconductor layer 7 for etching. By known etching methods, a plurality of recesses is formed on an upper side of the second oxide semiconductor layer 7 in the depth direction of the trench 10 shown in Fig. 2B at regular interval. Then, by using the mask for the etching, embedding the hole blocking layer 6 in the plurality of recesses. In this embodiment, the hole blocking layer 6 is preferably a plurality of hole blocking regions spaced along the bottom surface of the trench. The oxide semiconductor layer 3 is formed on the second semiconductor layer 7 in which the plurality of hole blocking regions is embedded, and then the first semiconductor region 12 is formed on the oxide semiconductor layer 3. Next, a mask for etching is disposed in an area on the first semiconductor region 12 except the area where the trench 10 is formed. By etching, the trench 10 is formed with depth to reach the hole blocking layer 6 through the first oxide semiconductor layer 3 from the upper surface of the first semiconductor region 12. Examples of method of forming the oxide semiconductor layer 7, the hole blocking layer 6, and the first semiconductor region 12 include a deposition method such as a MOCVD method, a mist CVD method, a mist epitaxy method, or a HVPE method. Next, the gate insulating film 1 is formed in the trench 10. Examples of method of forming the gate insulating film 1 include a CVD method, an atmospheric pressure CVD method, a Plasma CVD method, and a mist CVD method. The first electrode 11 (the gate electrode) is embedded in the trench 10 in which the gate insulating film 1 is disposed. The second electrode 15 may be formed on the previously formed inter-electrode insulating film 14. Although forming the third electrode 16 on the opposite side of the second electrode 15 is possible thereafter, the order of forming electrodes is not limited in the disclosure. Note that method of forming the first electrode 11, the second electrode 15, and the third electrode 16 is not particularly limited, and may be a known method. Examples of the method for forming the first electrode 11 or the second electrode 12 include sputtering, vacuum evaporation, and CVD.

The energy band diagram shown in Fig. 2D shows in the case of the gate voltage Vg of 0V. As can be seen, barrier to holes exists at the interface 8 between the hole blocking layer 6 as the p-type iridium gallium oxide layer and the gate insulating film 1 as a SiO film. The barrier height for holes at the interface 8 between the gate insulating film 1 and the hole blocking layer 6 is 1.0eV or more. With the configuration as described above, in the semiconductor device containing an oxide semiconductor such as a InAlGaO based semiconductor, it is possible to suppress the injection of holes into the gate insulating film 1. The semiconductor device 200 of this embodiment is MOSFET (Metal-Oxide-Semiconductor Field Effect Transistor), but is not limited thereto.

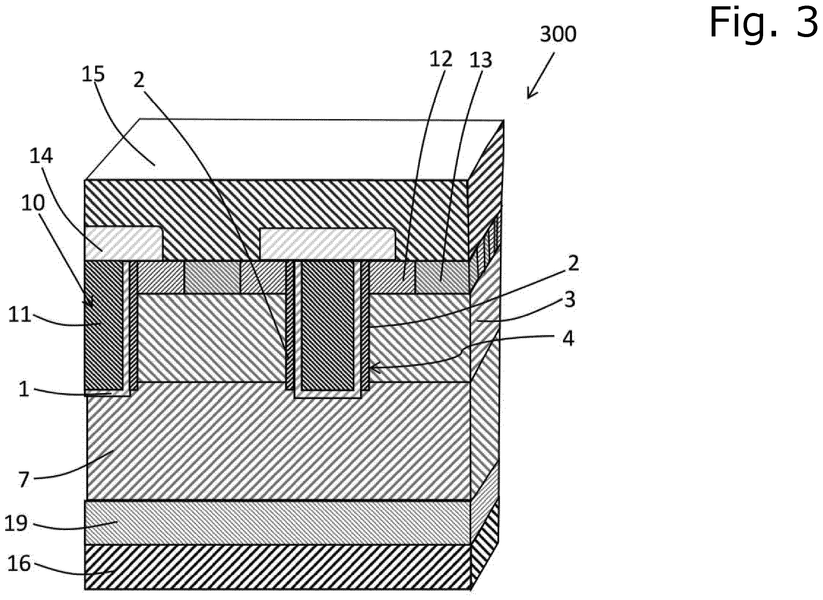

Fig. 3 is an overhead view illustrating an outline of a cross-sectional configuration of a semiconductor device according to a second embodiment of the disclosure. A semiconductor device 300 includes the gate insulating film 1, the hole blocking layer 2 placed in contact with the gate insulating film 1, and the oxide semiconductor layer 3 placed in contact with the hole blocking layer 2. The hole blocking layer 2 is provided between the gate insulating film 1 and the oxide semiconductor layer 3. Similar to the semiconductor device 100 shown in Fig. 1D, the hole blocking layer 2 extends so as to continuously cover the gate insulating film 1 arranged along the trench 10 at least in the longitudinal direction and the depth direction of the side surfaces of the gate insulating film 1. With this configuration, injection of holes from the oxide semiconductor layer 3 into the gate insulating film 1 may be suppressed. The difference between the above-explained semiconductor device 300 and the semiconductor device 100 of the first embodiment is that the oxide layer 19 (the p⁺-type oxide semiconductor layer) is provided in the semiconductor device 300, on the other hand, the oxide layer 9 (n⁺-type gallium oxide semiconductor layer) is provided in the semiconductor device 100. That is, the semiconductor device 300 includes the first electrode 11 (gate electrode) embedded in the trench 10, the inter-electrode insulating film 14 (emitter-gate film) provided to cover upper surfaces of the first electrode 11 and the gate insulating film 1 and to cover at least a part of the upper surface of the first semiconductor region 12, and the second electrode 15 (emitter electrode) provided to cover upper surfaces of the inter-electrode insulating film 14, the first semiconductor region 12, and the second semiconductor region 13. The semiconductor device 300 further includes the second oxide semiconductor layer 7 placed in contact with the semiconductor layer 3 (a first semiconductor layer) and provided such that the bottom of the trench 10 is embedded therein, an oxide layer 19 placed in contact with the second oxide semiconductor layer 7, and the third electrode 16 (a collector electrode) provided to be connected to the oxide layer 19. The semiconductor device 300 of this embodiment is IGBT(Insulated Gate Bipolar Transistor), but is not limited thereto.

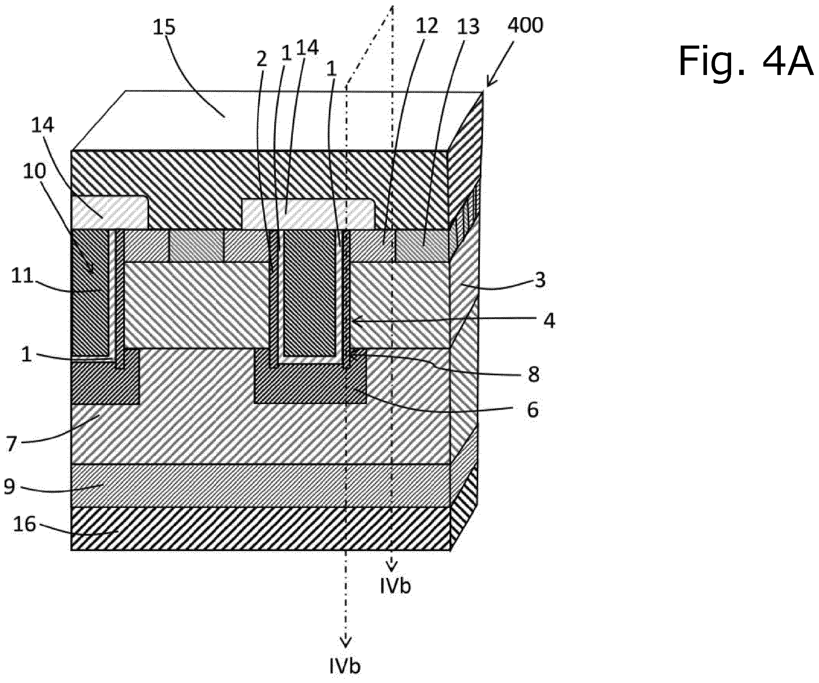

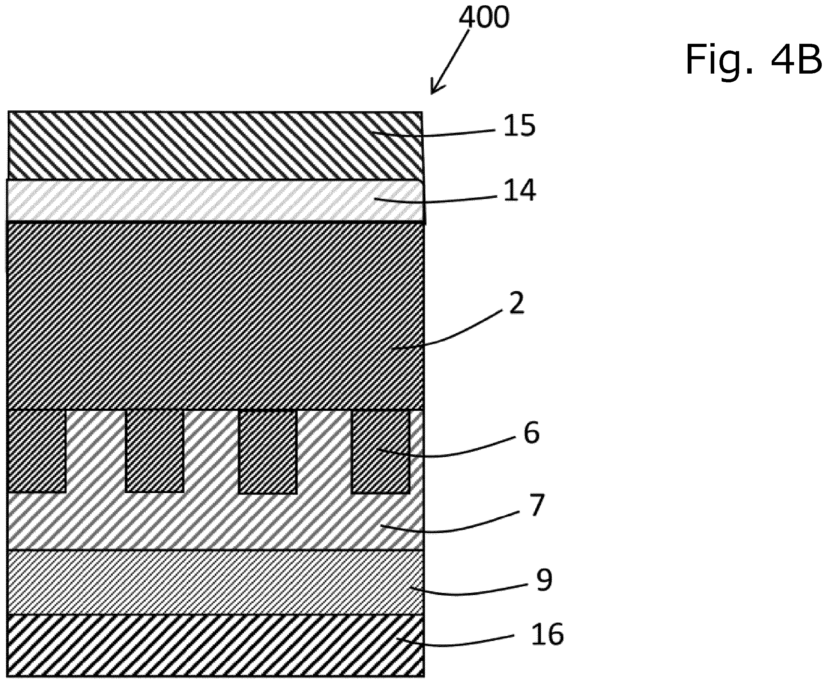

Fig. 4A is an overhead view illustrating an outline of a cross-sectional configuration of a semiconductor device according to the third embodiment of the disclosure. Fig. 4B is a cross-sectional view taken along IVb-IVb line of the semiconductor device shown in Fig. 4A. A semiconductor device 400 includes the gate insulating film 1, the n-type hole blocking layer 2 placed in contact with the gate insulating film 1, and the p-type oxide semiconductor layer 3 placed in contact with the n-type hole blocking layer 2. The semiconductor device 400 further includes the p-type hole blocking layer 6 placed in contact with at least a part of the gate insulating film 1, and the n-type oxide semiconductor layer 7 placed in contact with the p-type hole blocking layer 6. The p-type hole blocking layer 6 and the p-type oxide semiconductor layer 3 are partly connected to each other. By employing combined structure of the first and second embodiments, injection of holes to the gate insulating film 1 may be suppressed also at the bottom of the trench 10 where the gate insulating film 1 is provided, in addition to at the side surfaces thereof. Therefore, it is possible to suppress the degradation of the characteristics of the gate insulating film more favorably, and to provide a semiconductor device of more excellent reliability. It is preferable that at least a part of the lower end portion of the n-type hole blocking layer 2 is embedded in the p-type hole blocking layer 6. As shown in Fig. 4B, by extending the n-type hole blocking layer 2 so as to continuously cover the gate insulating film 1 arranged along the trench 10 at least in the longitudinal direction and the depth direction of the side surfaces of the gate insulating film 1, injection of holes from the oxide semiconductor layer 3 into the gate insulating film 1 may be suppressed. As shown in Fig. 4B, the p-type hole blocking layer 6 has a portion to cover the gate insulating film 1 at least at the bottom of the trench in the gate insulating film 1 arranged along the trench 10. In this embodiment, the p-type hole blocking layer 6 does not have to extend so as to continuously cover the gate insulating film 1. Injection of holes from the oxide semiconductor layer 7 into the gate insulating film 1 can be suppressed as long as at least the p-type hole blocking layer 6 is partially disposed. As for the method of forming the hole blocking layer 2 and the hole blocking layer 6 in this embodiment, the forming methods described in the first and second embodiments may be referred to as examples. The semiconductor device 400 of this embodiment is a MOSFET (Metal-Oxide-Semiconductor Field Effect Transistor), but is not limited thereto. The semiconductor device 400 of this embodiment may be used as an IGBT (Insulated Gate Bipolar Transistor) if an oxide layer 19 (p-type oxide layer) is employed instead of the oxide layer (n-type oxide layer) 9.

The crystal structure of the oxide semiconductor layer is not particularly limited. In one or more embodiments of the disclosure, when the oxide semiconductor layer is a Ga₂O₃ semiconductor layer, it is preferable that the oxide semiconductor layer has a corundum structure or a β-gallia structure.

The semiconductor device according to one or more embodiments of the disclosure is particularly useful in power devices such as MOSFET and IGBT having trench structure.

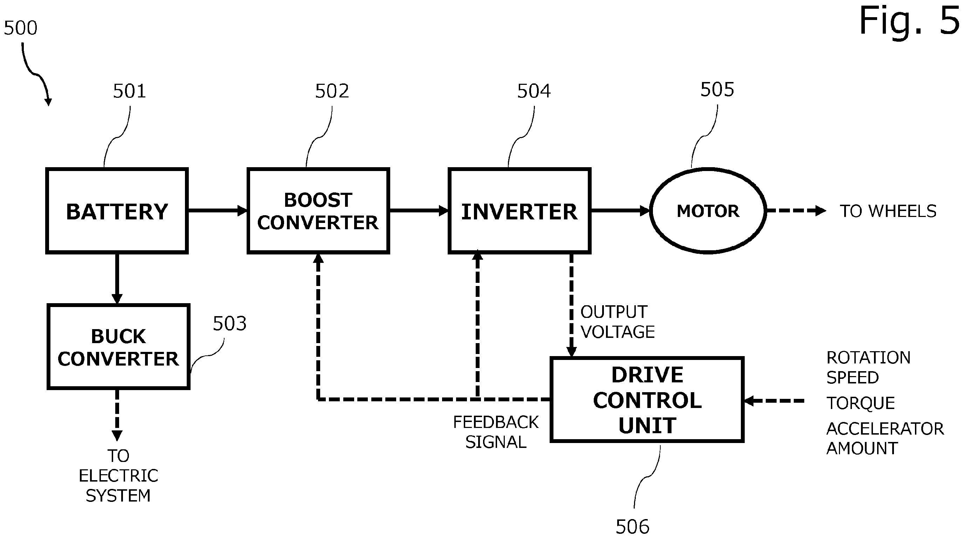

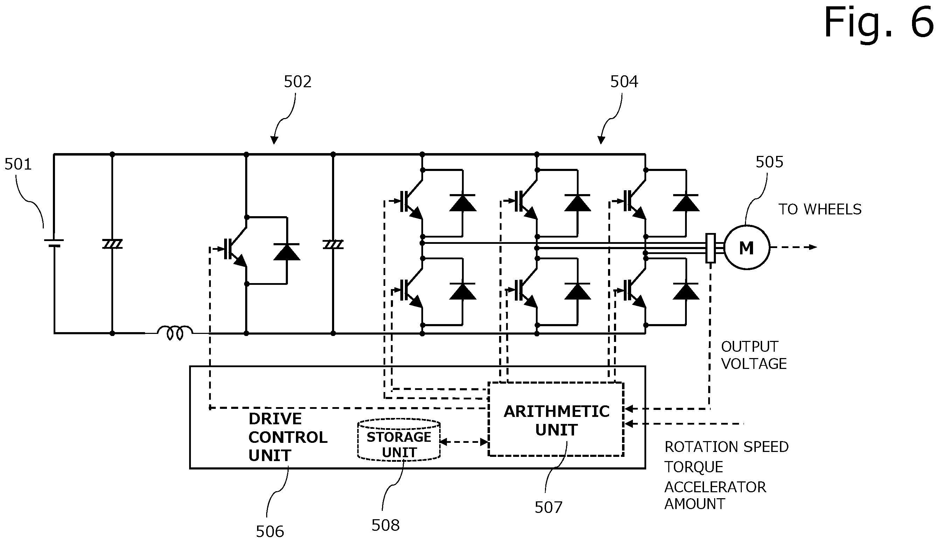

In order to exhibit the functions described above, the semiconductor device of the disclosure described above may be applied to a power converter such as an inverter or a converter. More specifically, it may be applied as a diode incorporated in the inverter or converter, a thyristor, a power transistor, an IGBT (Insulated Gate Bipolar Transistor), a MOSFET (Metal-Oxide-Semiconductor Field Effect Transistor) or the like as a switching element. Fig. 5 is a block diagram illustrating an exemplary control system applying a semiconductor device according to an embodiment of the disclosure, and Fig. 6 is a circuit diagram of the control system particularly suitable for applying to a control system of an electric vehicle.

As shown in Fig. 5, the control system 500 includes a battery (power supply) 501, a boost converter 502, a buck converter 503, an inverter 504, a motor (driving object) 505, a drive control unit 506, which are mounted on an electric vehicle. The battery 501 consists of, for example, a storage battery such as a nickel hydrogen battery or a lithium-ion battery. The battery 501 may store electric power by charging at the power supply station or regenerating at the time of deceleration, and to output a direct current (DC) voltage required for the operation of the driving system and the electrical system of the electric vehicle. The boost converter 502 is, for example, a voltage converter in which a chopper circuit is mounted, and may step-up DC voltage of, for example, 200V supplied from the battery 501 to, for example, 650V by switching operations of the chopper circuit. The step-up voltage may be supplied to a traveling system such as a motor. The buck converter 503 is also a voltage converter in which a chopper circuit is mounted, and may step-down DC voltage of, for example, 200V supplied from the battery 501 to, for example, about 12V The step-down voltage may be supplied to an electric system including a power window, a power steering, or an electric device mounted on a vehicle.

The inverter 504 converts the DC voltage supplied from the boost converter 502 into three-phase alternating current (AC) voltage by switching operations, and outputs to the motor 505. The motor 505 is a three-phase AC motor constituting the traveling system of an electric vehicle, and is driven by an AC voltage of the three-phase output from the inverter 504. The rotational driving force is transmitted to the wheels of the electric vehicle via a transmission mechanism (not shown).

On the other hand, actual values such as rotation speed and torque of the wheels, the amount of depression of the accelerator pedal (accelerator amount) are measured from an electric vehicle in cruising by using various sensors (not shown), The signals thus measured are input to the drive control unit 506. The output voltage value of the inverter 504 is also input to the drive control unit 506 at the same time. The drive control unit 506 has a function of a controller including an arithmetic unit such as a CPU (Central Processing Unit) and a data storage unit such as a memory, and generates a control signal using the inputted measurement signal and outputs the control signal as a feedback signal to the inverters 504, thereby controlling the switching operation by the switching elements. The AC voltage supplied to the motor 505 from the inverter 504 is thus corrected instantaneously, and the driving control of the electric vehicle may be executed accurately. Safety and comfortable operation of the electric vehicle is thereby realized. In addition, it is also possible to control the output voltage to the inverter 504 by providing a feedback signal from the drive control unit 506 to the boost converter 502.

Fig. 6 is a circuit configuration excluding the buck converter 503 in Fig. 5, in other words, a circuit configuration showing a configuration only for driving the motor 505. As shown in the same figure, the semiconductor device of the disclosure is provided for switching control by, for example, being applied to the boost controller 502 and the inverter 504 as a Schottky barrier diode. The boost converter 502 performs chopper control by incorporating the semiconductor device into the chopper circuit of the boost converter 502. Similarly, the inverter 504 performs switching control by incorporating the semiconductor device into the switching circuit including an IGBT of the inverter 504. The current may be stabilized by interposing an inductor (such as a coil) at the output of the battery 501. Also, the voltage may be stabilized by interposing a capacitor (such as an electrolytic capacitor) between each of the battery 501, the boost converter 502, and the inverter 504.

As indicated by a dotted line in Fig. 6, an arithmetic unit 507 including a CPU (Central Processing Unit) and a storage unit 508 including a nonvolatile memory are provided in the drive control unit 506. Signal input to the drive control unit 506 is given to the arithmetic unit 507, and a feedback signal for each semiconductor element is generated by performing the programmed operation as necessary. The storage unit 508 temporarily holds the calculation result by the calculation unit 507, stores physical constants and functions necessary for driving control in the form of a table, and outputs the physical constants, functions, and the like to the arithmetic unit 507 as appropriate. The arithmetic unit 507 and the storage unit 508 may be provided by a known configuration, and the processing capability and the like thereof may be arbitrarily selected.

As shown in Figs. 5 and 6, a diode and a switching element such as a thyristor, a power transistor, an IGBT, a MOSFET and the like is employed for the switching operation of the boost converter 502, the buck converter 503 and the inverter 504 in the control system 500. The use of gallium oxide (Ga₂O₃) specifically corundum-type gallium oxide (α-Ga₂O₃) as its materials for these semiconductor devices greatly improves switching properties. Further, extremely outstanding switching performance may be expected and miniaturization and cost reduction of the control system 500 may be realized by applying a semiconductor film or a semiconductor device of the disclosure. That is, each of the boost converter 502, the buck converter 503 and the inverter 504 may be expected to have the benefit of the disclosure, and the effect and the advantages may be expected in any one or combination of the boost converter 502, the buck converter 503 and the inverter 504, or in any one of the boost converter 502, the buck converter 503 and the inverter 504 together with the drive control unit 506.

The control system 500 described above is not only applicable to the control system of an electric vehicle of the semiconductor device of the disclosure, but may be applied to a control system for any applications such as to step-up and step-down the power from a DC power source, or convert the power from a DC to an AC. It is also possible to use a power source such as a solar cell as a battery.

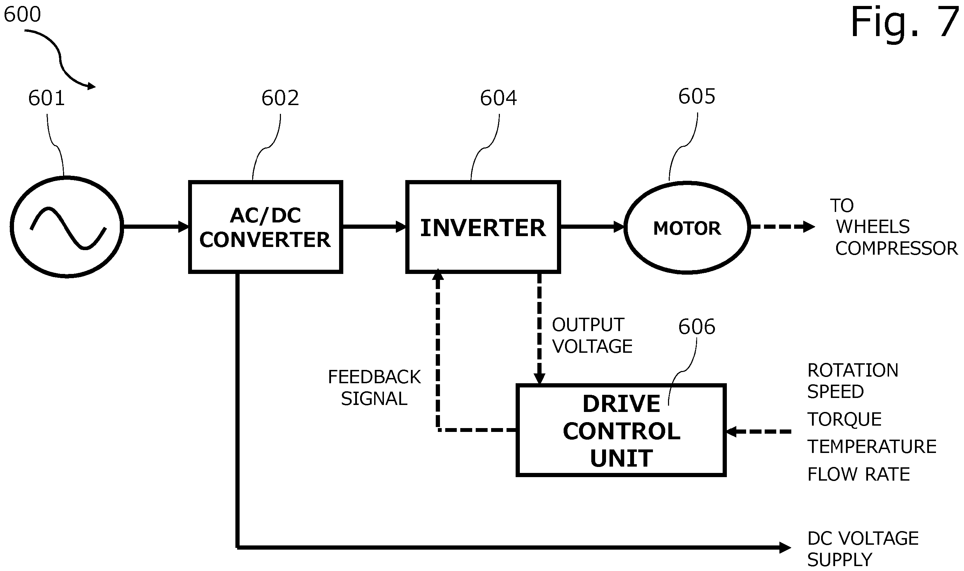

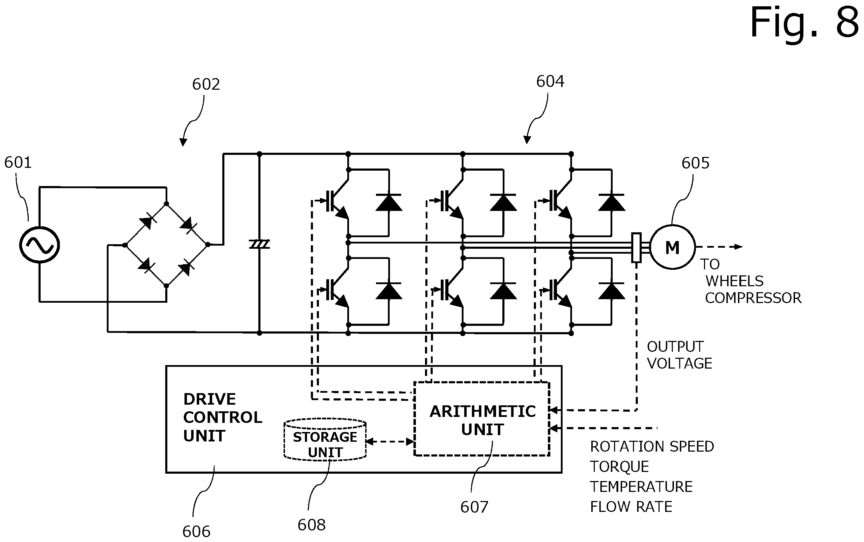

Fig. 7 is a block diagram illustrating another exemplary control system applying a semiconductor device according to an embodiment of the disclosure, and Fig. 8 is a circuit diagram of the control system suitable for applying to infrastructure equipment and home appliances or the like operable by the power from the AC power source.

As shown in Fig. 7, the control system 600 is provided for inputting power supplied from an external, such as a three-phase AC power source (power supply) 601, and includes an AC/DC converter 602, an inverter 604, a motor (driving object) 605 and a drive control unit 606 that may be applied to various devices described later. The three-phase AC power supply 601 is, for example, a power plant (such as a thermal, hydraulic, geothermal, or nuclear plant) of an electric power company, whose output is supplied as an AC voltage while being downgraded through substations. Further, the three-phase AC power supply 601 is installed in a building or a neighboring facility in the form of a private power generator or the like for supplying the generated power via a power cable. The AC/DC converter 602 is a voltage converter for converting AC voltage to DC voltage. The AC/DC converter 602 converts AC voltage of 100V or 200V supplied from the three-phase AC power supply 601 to a predetermined DC voltage. Specifically, AC voltage is converted by a transformer to a desired, commonly used voltage such as 3. 3V, 5V, or 12V When the driving object is a motor, conversion to 12V is performed. It is possible to adopt a single-phase AC power supply in place of the three-phase AC power supply. In this case, same system configuration may be realized if an AC/DC converter of the single-phase input is employed.

The inverter 604 converts the DC voltage supplied from the AC/DC converter 602 into three-phase AC voltage by switching operations and outputs to the motor 605. Configuration of the motor 605 is variable depending on the control object. It may be a wheel if the control object is a train, may be a pump and various power source if the control objects a factory equipment, may be a three-phase AC motor for driving a compressor or the like if the control object is a home appliance. The motor 605 is driven to rotate by the three-phase AC voltage output from the inverter 604, and transmits the rotational driving force to the driving object (not shown).

There are many kinds of driving objects such as personal computer, LED lighting equipment, video equipment, audio equipment and the like capable of directly supplying a DC voltage output from the AC/DC inverter 602. In that case the inverter 604 becomes unnecessary in the control system 600, and a DC voltage from the AC/DC inverter 602 is supplied to the driving object directly as shown in Fig. 7. Here, DC voltage of 3. 3V is supplied to personal computers and DC voltage of 5V is supplied to the LED lighting device for example.

On the other hand, rotation speed and torque of the driving object, measured values such as the temperature and flow rate of the peripheral environment of the driving object, for example, is measured using various sensors (not shown), these measured signals are input to the drive control unit 606. At the same time, the output voltage value of the inverter 604 is also input to the drive control unit 606. Based on these measured signals, the drive control unit 606 provides a feedback signal to the inverter 604 thereby controls switching operations by the switching element of the inverter 604. The AC voltage supplied to the motor 605 from the inverter 604 is thus corrected instantaneously, and the operation control of the driving object may be executed accurately. Stable operation of the driving object is thereby realized. In addition, when the driving object may be driven by a DC voltage, as described above, feedback control of the AC/DC controller 602 is possible in place of feedback control of the inverter.

Fig. 8 shows the circuit configuration of Fig. 7. As shown in Fig. 8, the semiconductor device of the disclosure is provided for switching control by, for example, being applied to the AC/DC converter 602 and the inverter 604 as a Schottky barrier diode. The AC/DC converter 602 has, for example, a circuit configuration in which Schottky barrier diodes are arranged in a bridge-shaped, to perform a direct-current conversion by converting and rectifying the negative component of the input voltage to a positive voltage. Schottky barrier diodes may also be applied to a switching circuit in IGBT of the inverter 604 to perform switching control. The voltage may be stabilized by interposing a capacitor (such as an electrolytic capacitor) between the AC/DC converter 602 and the inverter 604.

As indicated by a dotted line in Fig. 8, an arithmetic unit 607 including a CPU and a storage unit 608 including a nonvolatile memory are provided in the drive control unit 606. Signal input to the drive control unit 606 is given to the arithmetic unit 607, and a feedback signal for each semiconductor element is generated by performing the programmed operation as necessary. The storage unit 608 temporarily holds the calculation result by the arithmetic unit 607, stores physical constants and functions necessary for driving control in the form of a table, and outputs the physical constants, functions, and the like to the arithmetic unit 607 as appropriate. The arithmetic unit 607 and the storage unit 608 may be provided by a known configuration, and the processing capability and the like thereof may be arbitrarily selected.

In such a control system 600, similarly to the control system 500 shown in Figs. 5 and 6, a diode or a switching element such as a thyristor, a power transistor, an IGBT, a MOSFET or the like is also applied for the purpose of the rectification operation and switching operation of the AC/DC converter 602 and the inverter 604. Switching performance may be improved by the use of gallium oxide (Ga₂O₃), particularly corundum-type gallium oxide (α-Ga₂O₃), as materials for these semiconductor elements. Further, extremely outstanding switching performance may be expected and miniaturization and cost reduction of the control system 600may be realized by applying a semiconductor film or a semiconductor device of the disclosure. That is, each of the AC/DC converter 602 and the inverter 604may be expected to have the benefit of the disclosure, and the effects and the advantages of the disclosure may be expected in any one or combination of the AC/DC converter 602 and the inverter 604, or in any of the AC/DC converter 602 and the inverter 604 together with the drive control unit 606.

Although the motor 605 has been exemplified in Figs. 7 and 8, the driving object is not necessarily limited to those that operate mechanically. Many devices that require an AC voltage may be a driving object. It is possible to apply the control system 600 as long as electric power is obtained from AC power source to drive the driving object. The control system 600 may be applied to the driving control of any electric equipment such as infrastructure equipment (electric power facilities such as buildings and factories, telecommunication facilities, traffic control facilities, water and sewage treatment facilities, system equipment, labor-saving equipment, trains and the like) and home appliances (refrigerators, washing machines, personal computers, LED lighting equipment, video equipment, audio equipment and the like).

The semiconductor device of the disclosure is useful for power semiconductor device including trench structure. It is configured to suppress hole injections into the gate insulating film effectively, and is useful for power semiconductor devices and systems and facilities with power semiconductor devices.

### [Reference Signs List]

1: gate insulating film
2: hole blocking layer

3: oxide semiconductor layer
4: interface between the oxide semiconductor layer 3 and the hole blocking layer 2
6: hole blocking layer
7: oxide semiconductor layer
8: interface between the gate insulating film 1 and the hole blocking layer 6
9: oxide layer
10: trench:
11: first electrode
12: first semiconductor region
13: second semiconductor region
14: inter-electrode insulating film
15: second electrode:
16: third electrode
19: oxide layer (p-type oxide layer)
100: semiconductor device
200: semiconductor device
300: semiconductor device
400: semiconductor device
500: control system
   501: battery (power supply)
   502: boost converter
   503: buck converter
   504: inverter
   505: motor (driving object)
   506: drive control unit
   507: arithmetic unit
   508: storage unit:
   600: control system
   601: three-phase AC power source (power supply)
   602: AC/DC converter
   604: inverter
   605: motor (driving object)
   606: drive control unit
   607: arithmetic unit
   608: storage unit

## Claims

1. A semiconductor device comprising:
a gate insulating film;
a hole blocking layer placed in contact with the gate insulating film; and
an oxide semiconductor layer placed in contact with the hole blocking layer,
wherein the hole blocking layer is located between the gate insulating film and the oxide semiconductor layer.

2. The semiconductor device according to claim 1, wherein the hole blocking layer has a first conductivity type and the oxide semiconductor layer has a second conductivity type that differs from the first conductivity type.

3. The semiconductor device according to claim 1 or 2, wherein the band gap of the hole blocking layer and the band gap of the oxide semiconductor layer are different.

4. The semiconductor device according to any one of claims 1 to 3, wherein the hole blocking layer is an oxide layer.

5. The semiconductor device according to any one of claims 1 to 4, wherein the gate insulating film, the hole blocking layer, and the oxide semiconductor layer are partly arranged side by side in a horizontal direction in plan view.

6. The semiconductor device according to any of claims 1 to 5, wherein the hole blocking layer has n-type conductivity and the oxide semiconductor layer has p-type conductivity.

7. The semiconductor device according to claim 5 or 6, wherein the oxide semiconductor layer contains at least one metal selected from gallium, iridium, nickel, rhodium, and chromium.

8. The semiconductor device according to any one of claims 5 to 7, wherein an interface between the oxide semiconductor layer and the hole blocking layer forms a barrier that prevents injection of holes from the oxide semiconductor layer.

9. The semiconductor device according to any one of claims 5 to 8, wherein a barrier height to holes at the interface between the oxide semiconductor layer and the hole blocking layer is 1.0eV or more.

10. The semiconductor device according to any one of claims 1 to 4, wherein the oxide semiconductor layer has an n-type conductivity type.

11. The semiconductor device according to claim 10, wherein the hole blocking layer has p-type conductivity.

12. The semiconductor device according to claim 10 or 11, wherein the oxide semiconductor layer contains at least one metal selected from gallium, aluminum and indium.

13. The semiconductor device according to any one of claims 10 to 12, wherein an interface between the gate insulating film and the hole blocking layer forms a barrier that prevents injection of holes from the oxide semiconductor layer.

14. The semiconductor device according to any one of claims 10 to 13, wherein a barrier height to holes at the interface between the gate insulating film and the hole blocking layer is 1.0eV or more.

15. The semiconductor device according to any one of claims 5 to 14, further comprising an n-type oxide layer placed in contact with the oxide semiconducting layer.

16. The semiconductor device according to any one of claims 5 to 14, further comprising a p-type oxide layer placed in contact with the oxide semiconductor layer.

17. A semiconductor device comprising:
a gate insulating film;
an n-type hole blocking layer placed in contact with the gate insulating film;
a p-type oxide layer placed in contact with the n-type hole blocking layer;
a p-type hole blocking layer placed in contact with at least a part of the gate insulating film; and
an n-type oxide layer placed in contact with the p-type hole blocking layer,
wherein the p-type hole blocking layer and the p-type oxide layer are partly contacted.

18. A system comprising:
a circuit; and
a semiconductor device electrically connected to the circuit,
wherein the semiconductor device is of any one of claims 1-17.
